Europäisches Patentamt

European Patent Office

Office européen des brevets

(11) Publication number: **0 167 365**
**B1**

(12) **EUROPEAN PATENT SPECIFICATION**

(45) Date of publication of patent specification: **14.06.89**

(51) Int. Cl.⁴: **H 01 L 27/02**

(21) Application number: **85304629.0**

(22) Date of filing: **28.06.85**

(54) Standard cell LSIs.

(30) Priority: **29.06.84 JP 135410/84**

(43) Date of publication of application:
**08.01.86 Bulletin 86/02**

(45) Publication of the grant of the patent:
**14.06.89 Bulletin 89/24**

(84) Designated Contracting States:
**DE FR GB IT**

(56) References cited:
**US-A-4 125 854**
**US-A-4 161 662**

**COMPUTER DESIGN, vol. 23, no. 3, March 1984, pages 159-169, Winchester, Massachusetts, US; J.BOND: "Semicustom circuits arrive"**

(73) Proprietor: **FUJITSU LIMITED**
**1015, Kamikodanaka Nakahara-ku**
**Kawasaki-shi Kanagawa 211 (JP)**

(72) Inventor: **Aneha, Nobuhiko c/o Fujitsu Limited**
**Patent Department 1015 Kamikodanaka**
**Nakahara-ku**
**Kawasaki-shi Kanagawa 211 (JP)**
Inventor: **Baba, Shigenori c/o Fujitsu Limited**
**Patent Department 1015 Kamikodanaka**
**Nakahara-ku**
**Kawasaki-shi Kanagawa 211 (JP)**

(74) Representative: **Sunderland, James Harry et al**
**HASELTINE LAKE & CO Hazlitt House 28**
**Southampton Buildings Chancery Lane**
**London WC2A 1AT (GB)**

Courier Press, Leamington Spa, England.

## Description

This invention relates to semiconductor integrated circuits, and concerns more specifically circuit pattern design of logic LSIs based on so-called standard cell methodology.

Recent fine patterning technology for semiconductor circuits makes it possible to provide logic LSIs having as many as a few to tens of thousands of gates per chip. On the other hand, there is increasing demand for a variety of logic LSIs tailored to meet users' specific requirements. The scale of production of such customised logic LSIs is usually small in comparison with the scale of production of standardised LSIs, memory LSIs for example, and such customised logic LSIs are required to be produced with a short turnaround time from design to shipment.

Providing a fully-customised LSI necessarily starts with the design and placement of transistors on a chip, and design optimization is directed to maximising the efficiency of chip area utilization and performance of the circuit of the chip. However, such full custom design has disadvantages; a long turnaround time, as much as half a year or more, will generally be needed; and low flexibility in relation to modification of chip design which has been highly optimized. Therefore, several methodologies such as gate array and standard cell methods have been proposed for developing customised LSIs with short turnaround time and design flexibility.

In the gate array method, a customised logic LSI is fabricated by providing only wirings for establishing a desired circuit network on a silicon wafer already held in stock, on which transistors are formed in advance. The number of masks necessary for the customisation is about 1/3 of the total number of masks used in the fabrication of the LSI.

The standard cell method uses pre-defined patterns of unit circuits -cells- corresponding to logic gates such as NANDs, NORs, inverters and flip-flops, etc. The patterns of the cells are registered as a library in a computer system. The design of an LSI chip is carried out on the basis of the placement and interconnection routing of such cells with the support of a CAD (computer aided design) system and the whole (all) masks are customized for each kind of LSI which is customised.

The standard cell method has the following features:

(a) information on the patterns and electrical characteristics of circuit elements such as transistors is well-organized in the library of the CAD system, so efficient control of the LSI chip design can be attained;

(b) as a result, errors which might arise in the chip design can be decreased;

(c) efficient use of chip area can be achieved as compared with the gate array method.

Thus, the standard cell method offers a relatively large degree of freedom in relation to chip design, provides the possibility of LSI design without expert knowledge of circuit elements, and permits the risks involved in the development of the LSI to be reduced.

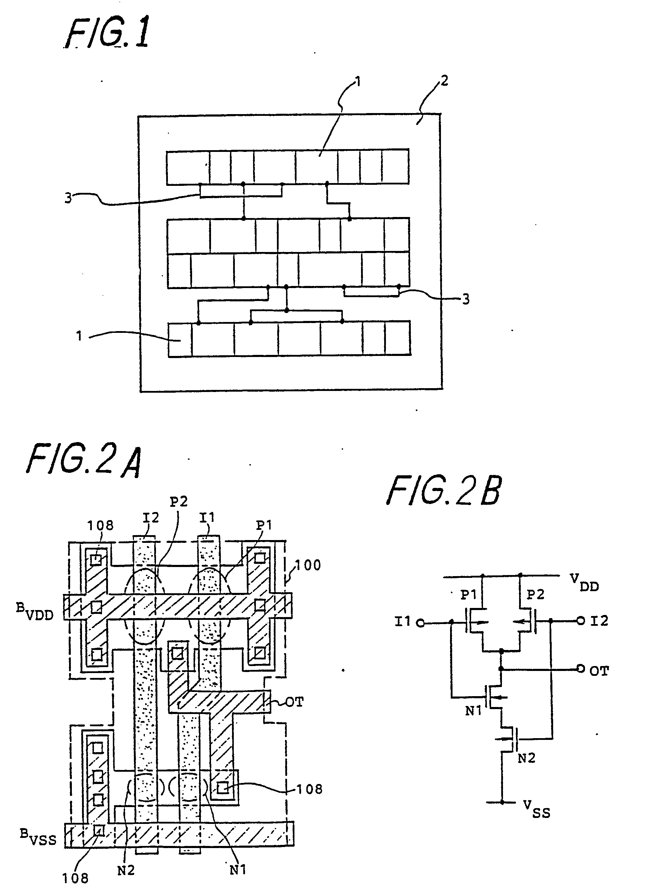

Fig. 1 is a schematic conceptual diagram showing an example of placement and interconnection-routing of cells in accordance with a standard cell method. Referring to Fig. 1, various kinds of cells 1 are arranged in rows on a semiconductor substrate 2. The cells are each formed in a substantially rectangular frame. Each frame is of the same height but the widths of the frames differ for different kinds of cell. The cells are interconnected by wirings 3 formed so as to be distributed in regions (sometimes referred to as wiring channels) between adjacent cell rows. Each of the cells 1 has a pre-defined pattern for providing circuit elements such as transistors and inner wiring layers therein. Fig. 2A shows an exemplary pattern providing a 2-input NAND gate of CMOS (complementary metal oxide semiconductor) type logic in a frame, corresponding to an equivalent circuit as shown in Fig. 2B.

Referring to Fig. 2A, the 2-input NAND cell occupies an area defined by a substantially rectangular virtual frame indicated by a broken line 100 in Fig. 2A. The dimensions of the frame are of the order of about a few tens to one hundred microns. Circuit components such as MOS transistors P1, P2, N1, and N2 are formed in the frame, while nodes for external connections are formed to extend across the frame 100. In Fig. 2A, hatched areas illustrate wiring layers of aluminium (A1), for example. I1 and I2 indicate nodes for receiving input signals and OT represents an output node. $B_{VDD}$ and $B_{VSS}$ are the bus lines to be connected to positive and negative side voltage sources $V_{DD}$ and $V_{SS}$, respectively.

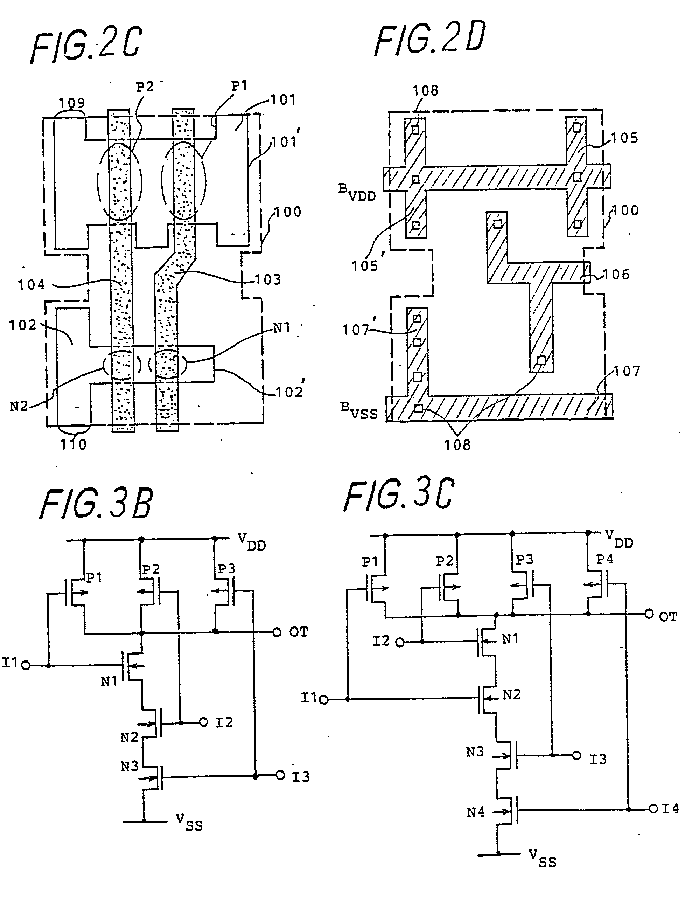

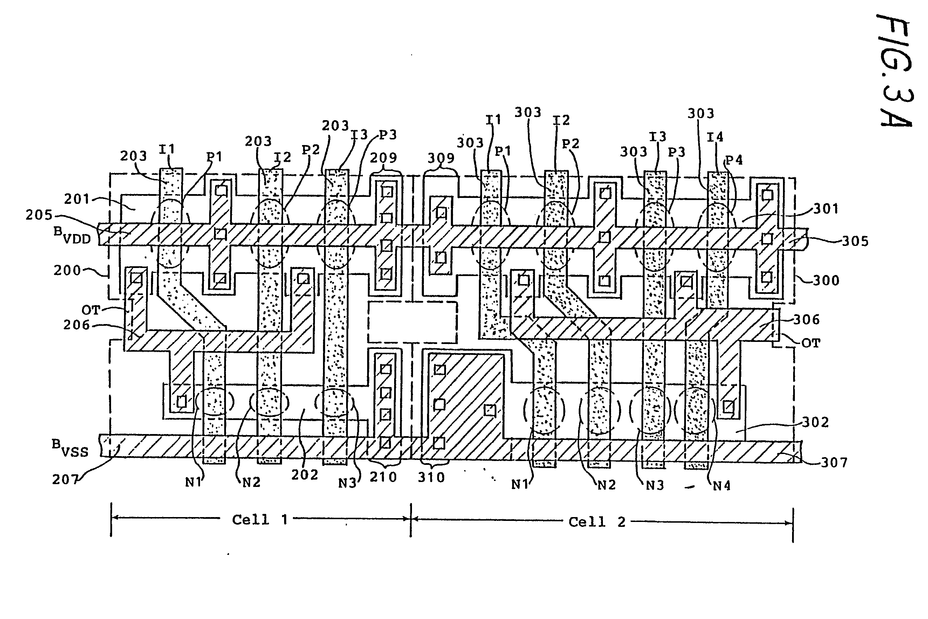

For assistance in understanding, the configuration of the pattern shown in Fig. 2A will be further explained with reference to Figs. 2C and 2D. Fig. 2C is a schematic diagram illustrating a bulk pattern providing the MOS transistors P1, P2, N1 and N2, and Fig. 2D is a schematic diagram illustrating the pattern of inner wiring layers interconnecting the transistors, including layers for the bus lines $B_{VDD}$ and $B_{VSS}$.

Referring to Fig. 2C. a p-type region 101 (enclosed by solid line 101') and an n-type region 102 (enclosed by solid line 102') are formed in the frame 100 by selectively implanting p-type and n-type impurities. The area outside the regions 101 and 102 is coated with a thick insulating layer (not shown), for example, an oxide layer generally referred to as a "field oxide layer". A couple of gate electrodes 103 and 104, both composed of polysilicon, for example, are formed across the p-type and n-type regions I01 and 102 with the interposition of respective thin insulating layers (not shown), such as oxide layers generally referred to as "gate oxide layers", between the gate electrodes and the regions 101 and 102. Thus, p-channel MOS transistors P1 and P2 in the p-type region 101 and n-channel NOS transistors N1 and N2 in the n-type region 102 are fabricated. The p-type region 101 and n-type region 102 are respectively provided with extra regions 109 and 110, which are referred to as bus line contact regions hereinafter and respective contacts to the bus lines $B_{VDD}$ and $B_{VSS}$ are formed therein as described later.

A set of wiring patterns 105, 106 and 107 as shown in Fig. 2D, composed of aluminium, for example, are fabricated on the bulk pattern of Fig. 2C. The wiring patterns have contacts to the bulk pattern through (contact) windows 108 formed in the (thick) insulating layer (not shown) at the positions as indicated in Figs. 2A and 2D. Thus, the p-channel transistors P1 and P2 and n-channel transistors N1 and N2 are interconnected with one another to form a 2-input NAND gate as shown in Fig. 2B. On extended portions 105' and 107' of the wiring patterns 105 and 107, which portions extend in the vertical direction of (with respect to) the bus lines $B_{VDD}$ and $B_{VSS}$ there are provided contact points to the corresponding underlying portions of the p-type and n-type regions (to the aforesaid bus line contact regions 109 and 110) to supply the latter portions with positive and ground potential, respectively. The region occupied by such extended portions 105' and 107' of the bus lines and their corresponding underlying p-type and n-type portions are referred to as bus line contact regions. The configurations of other logic cells including 3 or 4-input NAND gates, NOR gates, inverters etc. are essentially similar to the configuration explained with reference to Figs. 2C and 2D.

For generating a final bulk pattern of a logic circuit cell as shown in Fig. 2A, individual mask patterns for each of the processes, for example, those for creating p-type and n-type regions, gate electrodes, wiring lines, etc., are designed. A complete set of information relevant to the mask patterns for each kind of cell is registered in a library of a CAD system. In LSI chip design, therefore, when a designer has an access to the library by using the name of a desired cell, the frame of the cell is given on a display device; and he is requested only to determine the location of the cell frame and the routing of interconnections among cells (to other cells). The pattern information of all of the cells disposed on a chip is edited and stored in a mask pattern data file. Thus, a comprehensive mask pattern is generated for each production process relevant to all the cells by a computer system.

Fig. 3A is a schematic diagram illustrating a partial bulk pattern of a CMOS-LSI, showing a 3-input NAND gate (cell 1) and a 4-input NAND gate (cell 2) abutting each other, together with internal wiring layers (hatched patterns) formed thereon, placed according to a previously proposed standard cell placement rule. Figs. 3B and 3C are the respective equivalent circuits of the 3-input and 4-input NAND gates of Fig. 3A.

Referring to Fig. 3A, cells 1 and 2 are defined in respective virtual frames (shown by broken lines) denoted by references 200 and 300. The cell 1 includes a p-type region 201, n-type region 202 and three gate electrodes 203, all for providing p-channel transistors P1, P2 and P3 and n-channel transistors N1, N2 and N3. The cell 2 includes a p-type region 301, n-type region 302 and four gate electrodes 303, all for providing p-channel transistors P1, P2, P3 and P4 and n-channel transistors N1, N2, N3 and N4. The transistors in the cells 1 and 2 are interconnected by respective sets of internal wiring layers; one set consisting of 205, 206 and 207, and the other set consisting of 305, 306 and 307. Thus, a 3-input NAND gate and a 4-input NAND gate are provided in the frames 200 and 300, respectively. The wiring layers 205 and 305 are connected to each other with their nodes extending out across the frames 200 and 300, respectively, and the wiring layers 207 and 307 are connected to each other with their nodes extending out across the frames 200 and 300, respectively, thus the respective bus lines $B_{VDD}$ and $B_{VSS}$ can run throughout the cells in the row.

Again, pattern information relating to these cells together with that relating to other cells placed on the same chip is processed in a CAD system, and an individual mask pattern for each fabrication process is generated in common with all of the cells. Such mask patterns include those for defining regions to be characterised as the p-type and n-type regions later; providing mask layers for the regions to which p-type and n-type impurities are selectively diffused, respectively; delineating the gate electrodes and the wiring layers, respectively.

As described above, in the previously proposed standard cell method, adjoining cells are disposed to have their frames abutting each other, and effective use of chip area is limited by elaboration in the cell placement to minimize the region allocated for the aforesaid wiring channels. Even if the area used for wiring channels is minimized, in general the efficiency which can be achieved is far less than that which can be achieved with a fully customised chip. Therefore, improvement in chip area utilization has been a matter of serious concern in relation to standard cell methodology. An example of the above described prior art can be found in US—A—4 161 662.

According to the present invention there is provided a semiconductor integrated circuit device, formed on the basis of standard cell methodology employing standard cells of different kinds each kind having a bulk pattern providing a predetermined set of circuit elements forming a respective unit circuit, said circuit elements being provided in a row of standard cells, wherein the row includes at least two adjoining cells of two different kinds, characterized in that: the bulk pattern of each of those two different cell kinds includes a pair of regions, for receiving respective power supply voltages, at one side of the cell, said pair of regions being designed to be standardized in common for each of various kinds of cells, and wherein the two cells are disposed in the row so that their bulk patterns partially overlap where said pair of regions are abutting each other, so that they effectively share in common one such pair of regions.

According to the present invention there is also provided a method of fabricating a semiconductor integrated circuit device in accordance with the invention on the basis of standard cell methodology employing standard cells of different kinds each kind having a bulk pattern providing a predetermined set of circuit elements forming a respective unit circuit, the method including

a first step for designing the circuitry of the device by virtually placing cells of different kinds in desired dispositions, employing cell pattern information registered in advance, and

a second step for generating a real pattern for the circuitry to be formed on a semiconductor device chip,

the first step including providing cell pattern information for establishing a plurality of cell kinds with respective cell patterns each having a pair of regions,

corresponding . to portions for receiving respective power supply voltages in a fabricated cell, and

virtually placing two cells, of two different cell kinds of the plurality, such that they adjoin one another and such that the said pair of regions in the cell pattern of one of those cells overlap the said pair of regions in the cell pattern of the other of those cells, whereby a real pattern corresponding to those two cells, formed in the second step, features portions for receiving respective power supply voltages shared in common by those two cells.

According to the present invention there is provided a CAD system, for designing a semiconductor integrated circuit device in accordance with the invention on the basis of standard cell methodology employing standard cells of different kinds each kind corresponding to a bulk pattern providing a predetermined set of circuit elements forming a respective unit circuit in a fabricated semiconductor integrated circuit device, the system comprising a cell library, storing cell pattern information for a plurality of cell kinds, each cell kind having a cell pattern including a pair of regions corresponding to portions for receiving respective power supply voltages in a fabricated cell, a display, and means whereby an operator can call up, from the cell library, information concerning each cell kind, the system being operable so that the display shows a schematic of a cell of a called-up cell kind, and so that the operator can selectively position the schematic, on the display,

the system being further operable so that the schematic includes an indication of the position of the said pair of regions and an indication of the extent to which the schematic can be overlapped with the schematic of another cell so that in a finished semiconductor integrated circuit device two cells corresponding to the overlapped schematics share in common such portions for receiving respective power supply voltages.

An embodiment of the present invention can provide for an LSI with improved chip area utilization.

An embodiment of the present invention can provide for improvement of chip area utilization of an LSI having a standard cell configuration.

Referring back to Fig. 3A, the inventors have had the insight that bus line contact regions 209 and 309 relating to bus line $B_{VDD}$ and respective corresponding underlying portions of the p-type regions 201 and 301 need not necessarily be independent from one another so far as their functions are concerned. The inventors have also had the insight that the same is true for bus line contact regions 210 and 310 relating to bus line $B_{VSS}$ and the respective corresponding underlying portions of the n-type regions 202 and 302.

The inventors have further devised means whereby two cells, such as the cells 1 and 2, abutting each other in a row can partially overlap with each other so that they can share bus line contact regions in common for each of the bus lines $B_{VDD}$ and $B_{VSS}$.

In accordance with an embodiment of the present invention, a pattern of bus line contact regions is designed to be standardised in common for each of various kinds of cell (e.g. for every kind of cell), and additional information for indicating the regions or zones occupied by the standardized bus line contact regions is added to the pattern information of each cell. At the state of LSI chip design, cells are arranged taking into account the additional information indicating such regions or zones, which it is possible to overlap one with another. Thus, in a logic LSI based on the standard cell methodology according to an embodiment of the present invention, a pair of desired circuit cells arranged to adjoin each other in a row have a pair of bus line contact regions for the bus lines $B_{VDD}$ and $B_{VSS}$ which are shared in common with one another if they can overlap each other. As a result, the total chip area occupied by the cells decreases in proportion to the number of such overlappings.

As shown in the bulk patterns of Figs. 2A and 3A, each of the circuit cells has only one pair of bus line contact regions, adjacent to one vertical side of the cell or cell frame, which can be standardized in general. Accordingly, two adjoining cells having their bus line contact regions on the same sides (e.g. two cells of the same kind) can not have a common pair of bus contact regions. In this case, in an embodiment of the present invention, it is provided that an inverted pattern or mirror image pattern of one of the cells is called and placed to partially overlap with the corresponding non-inverted pattern of the other of the two adjoining cells. Greater definition and more details of the inversion will be given below together with, an explanation of disadvantages arising when a cell is provided with two pairs of bus line contact regions (one pair at each vertical side of the cell or cell frame) in order to permit two adjoining cells to overlap each other (even if they are of the same kind) without an inversion procedure.

Reference is made, by way of example, to the accompanying drawings, in which:-

Fig. 1 is a schematic conceptual diagram showing an example of placement and interconnection routing of standard cells in a logic LSI designed using s standard cell methodology,

Fig. 2A is a schematic diagram showing an exemplary pattern providing a 2-input CMOS NAND gate cell;

Fig. 2B is an equivalent circuit diagram of the 2-input NAND gate shown in Fig. 2A;

Fig. 2C is a schematic diagram showing a bulk pattern of MOS transistors for constituting the 2-input NAND gate as shown in Fig. 2A;

Fig. 2D is a schematic diagram showing patterns of inner wiring layers formed on the bulk pattern shown in Fig 2C;

Fig. 3A is a schematic diagram showing a partial configuration of a CMOS-LSI comprising a 3-input NAND gate cell and 4-input NAND gate cell placed to abut on each other according to a previously proposed standard cell placement rule;

Figs. 3B and 3C are respective equivalent circuit diagrams of the 3-input and 4-input NAND gates in Fig. 3A;

Fig. 4 is a schematic block diagram illustrating the conceptual configuration of CAD system used for implementing a standard cell method according to an embodiment of the present invention;

Fig. 5A schematically illustrates a cell frame as displayed on the screen of a display terminal in a CAD system in accordance with an embodiment of the present invention;

Figs 5B and 5C are schematic and simplified illustrations of the frames of two cells, wherein the former illustrates cells abutting each other and the latter illustrates cells sharing an overlapped region, respectively;

Fig. 6 is a flow chart illustrating a process relevant to cell placement according to an embodiment of the present invention;

Fig. 7 is a schematic diagram showing a partial configuration of a CMOS-LSI comprising NAND gate cells placed to overlap with each other in accordance with an embodiment of the present invention;

Figs. 8A and 8B are respectively, a schematic diagram showing an exemplary bulk pattern of a CMOS inverter cell and an equivalent circuit diagram of the inverter cell;

Fig. 8C is a schematic diagram showing a pair of inverter cells placed to partially overlap each other in accordance with an embodiment of the present invention;

Fig. 9A is a schematic diagram showing a partial bulk pattern of a logic LSI comprising different kinds of CMOS gates consecutively disposed in a row; and

Fig. 9B is an equivalent circuit diagram of a 2-input NOR gate.

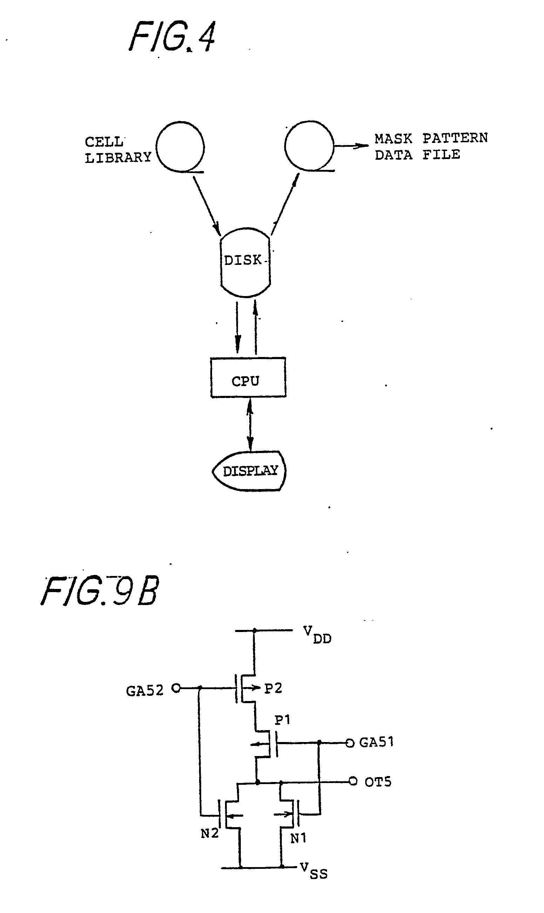

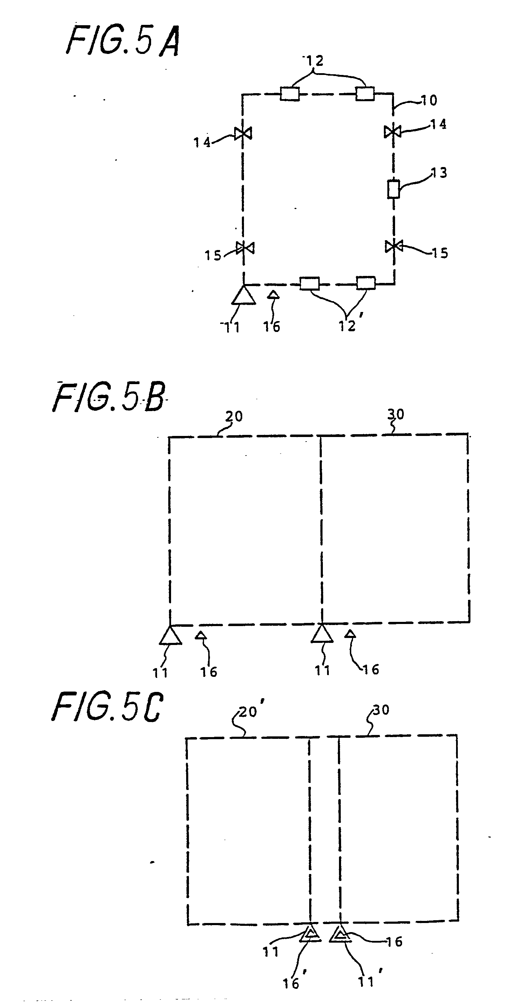

Referring to Fig. 4, a schematic block diagram illustrating a conceptual configuration of CAD system used for the standard cell method according to an embodiment of the present invention, pattern information of various standard cells (i.e. logic circuit blocks such as NAND, NOR, etc.) is stored in a cell library CELL LIBRARY. When an operator requests a central processing unit CPU to access the cell library by inputting the name of a desired cell, the pattern information of the cell is loaded into a random access memory such as the disk storage DISK, and the frame of the cell and some optional signs, as shown in Fig. 5A, are displayed on the screen of a display terminal DISPLAY. In the same manner, cells of the same kind or of different kind are called onto the screen by their names. The position of each cell on the screen can be arbitrarily selected by the operator.

In Fig. 5A, a large triangle 11 is provided for indicating the position of a cell frame 10 on a coordinate plane defined in the CAD; therefore, it is referred to as "origin information". Small rectangles 12 and 12' are for indicating the positions of input nodes such as I1, I2, etc. in Figs. 2A and Fig. 3A, whilst a rectangle 13 is for indicating the position of an output node such as OT. Signs 14 and 15, resembling butterflies, indicate nodes for the bus lines $B_{VDD}$ and $B_{VSS}$ in Figs. 2A or 3A, respectively. The small triangle 16 is a sign newly added to the pattern information of logic circuit cells in accordance with an embodiment of the present invention.

The sign 16, referred to as auxiliary origin information, is for indicating the regions or zone of the cell permitted to overlap with an adjacent cell. That is, when the frames 20 and 30 of the two cells are disposed to abut each other as shown in Fig. 5B, and there is no restriction for the cells to overlap each other, another frame having a mirror image relationship to the frame 20 with respect to a vertical axis is fetched to replace the frame 20, (such frame is referred to as an inverted frame, hereinafter). Then, the positions of the frame 30 and inverted frame 20' are adjusted to partially overlap each other as shown in Fig. 5C. In Fig. 5C, the origin information 11' and auxiliary origin information 16' are relevant to the frame 20', while the origin information 11 and the auxiliary origin information 16 are relevant to the frame 30. If the operator foresees the possibility of overlapping of desired cells prior to the fetching of their pattern information, he can obtain an inverted frame such as 20' in the step corresponding to that explained with reference to Fig. 5B.

In accordance with an embodiment of the present invention, it is enough to devise such overlap between pairs of adjoining cells because the pre-defined pattern of each cell generally has a single pair of regions which can be used in common with another cell as shown in Fig. 2A or 3A. It is possible, of course, to design a cell to have two pairs of regions to facilitate overlapping of the cell with either or both other cells disposed to its opposite sides.

However, a cell so designed will in general have a large lateral dimension.

Moreover, some kinds of cell have no regions which are (can be) allotted for overlapping with others, as a result of the natures of the patterns of the cells, and providing such cells with regions suitable for overlapping other cells also results in the disadvantage of increased cell width. For such cells it is unnecessary to add auxiliary origin information as mentioned with reference to Fig. 5B.

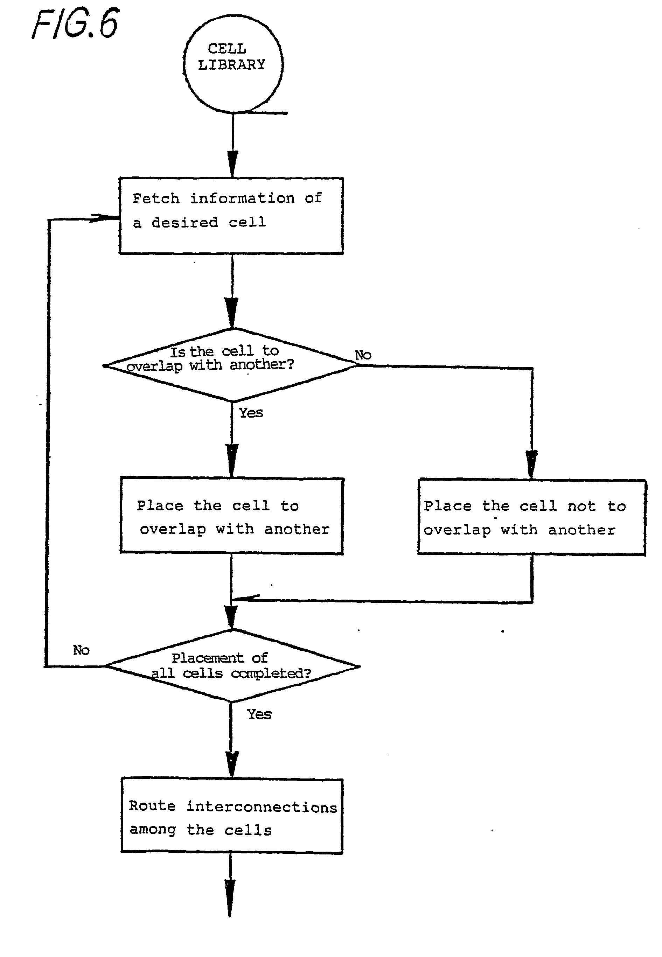

Fig. 6 is a flow chart illustrating processes relevant to cell placement according to an embodiment of the present invention. When a cell is called with its name, relevant cell information is fetched from a cell library and the frame of the cell is generated on a display screen. In accordance with this embodiment of the present invention, an extra step is provided for making a decision whether or not the cell is to be placed in overlapping relationship with another cell already on the display screen. If a decision is made that the cell it is to be placed without overlap with another cell, the frame of the cell is placed in the same manner as in the previously proposed standard cell methodology. If it is decided to make the cell overlap with another cell, the frames of the cells involved are so placed as to have a common region as explained with reference to Fig. 5C. Thus, each cell is subjected to a decision step as it is called and placed on the display screen, as cells are called one after another, until the placement of all cells to be disposed on a chip is finished. After the completion of placement, routing of interconnecting wiring among the cells as illustrated in Fig. 1 is carried out.

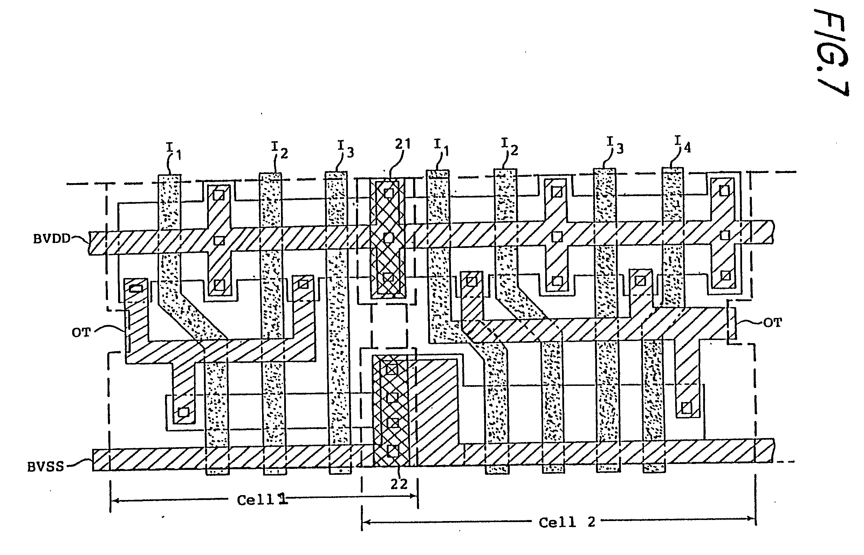

Fig. 7 is a schematic diagram showing a partial configuration of a CMOS-LSI comprising a 3-input NAND gate cell 1 and 4-input NAND gate cell 2 placed so as partially to overlap each other in accordance with an embodiment of the present invention. The configurations of the NAND gate cells in Fig. 7 are similar to those of the equivalent cells in Fig. 3A, and like references in Figs. 7 and 3A designate like or corresponding parts. Compared with Fig. 3A, the 3-input NAND gate cell 1 and 4-input NAND gate cell 2 in Fig. 7 have bus line contact regions 21 and 22 in common with each other (cross-hatched regions), and a reduction in the area occupied by the cells (in Fig. 7 as compared with Fig. 3A) amounts to the overlapping area.

As mentioned above, in accordance with an embodiment of the present invention, the pattern information of the 3-input NAND gate cell 1 and 4-input NAND gate cell 2 is modified in advance and registered to enable the overlapping of the bus line contact regions. That is, in contrast to Fig. 3A, wherein corresponding bus line contact regions of cells 1 and 2 have respective individual patterns, the corresponding bus line contact regions in this embodiment are standardized to have a pattern in common with each other and registered in the cell library. Hence, placement of cells can be carried out without regard to the pattern in each cell as in the previous proposal.

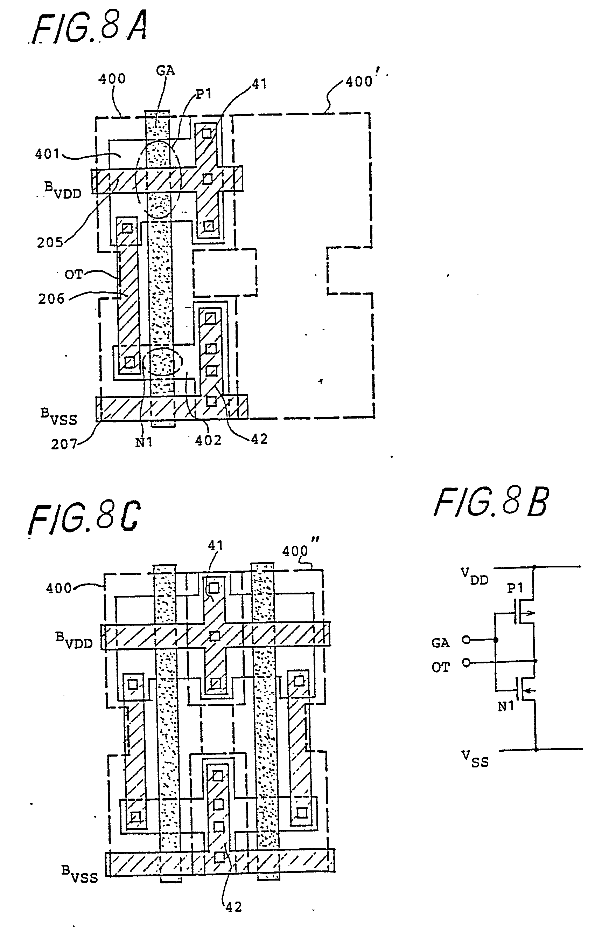

Fig. 8A shows an example of the bulk pattern of a CMOS inverter cell corresponding to the equivalent circuit as shown in Fig. 8B. In a frame 400, the inverter cell comprises a p-type region 401 and an n-type region 402 in which a p-channel MOS transistor P1 and an n-channel MOS transistor N1 are formed, respectively. The transistors P1 and N1 have a common gate electrode GA, a layer of polysilicon for example, and are interconnected by wiring layers 205, 206 and 207 of aluminium for example. The wiring layers 205 and 207 respectively constitute the bus lines $B_{VDD}$ and $B_{VSS}$.

In the previously proposed standard cell placement, frames 400 and 400' of two such inverter cells are placed to abut each other as shown in Fig. 8A, the pattern in the frame 400' being the same as that in the frame 400. On the other hand, in the placement according to the embodiment of the present invention, an inverted or mirror image pattern, of an inverter cell, as indicated by frame 400'', is called and is placed to partially overlap with the frame 400 as shown in Fig. 8C. Thus, the inverter cells 400 and 400'' have a pair of bus line contact regions 41 and 42 in common with each other. Comparing Fig. 8C with Fig. 8A, it will be clear that a reduction of total chip area occupied by the inverter cells can be achieved; the reduction being equal to the overlapping area of the cells.

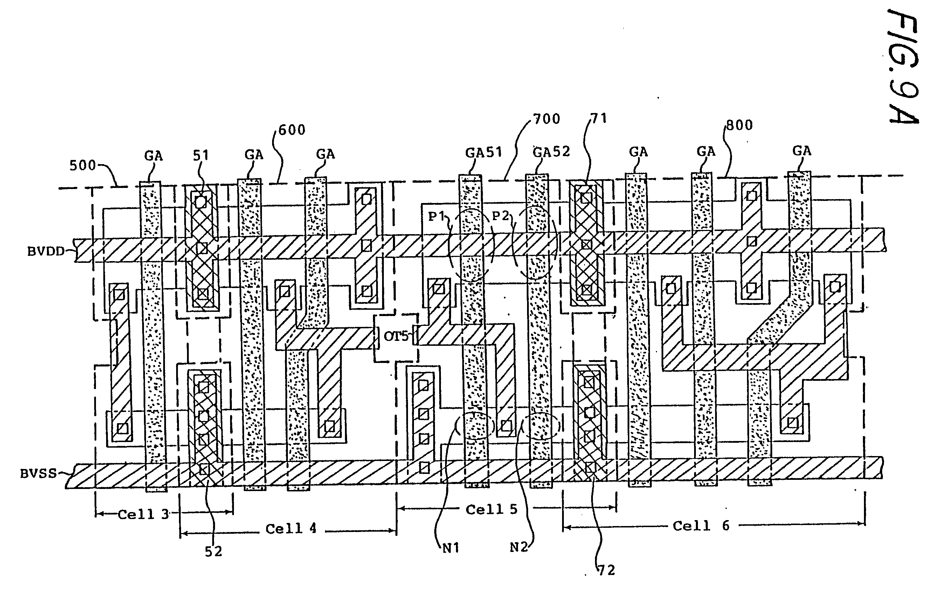

Fig. 9A shows a partial bulk pattern of a logic LSI comprising CMOS gates including an inverter (cell 3), a 2-input NAND (cell 4), a 2-input NOR (cell 5) and a 3-input NAND (cell 6) consecutively disposed in a row, each cell having an equivalent circuit as previously illustrated except for the 2-input NOR cell 5.

Figure 9B shows the equivalent circuit of the 2-input NOR cell 5.

The bulk patterns of the inverter cell 3 and 2-input NAND cell 4 are shown in Figs. 8A and 2A, respectively, while the cell 6 has a bulk pattern which is the inversion of the pattern of the 3-input NAND cell 1 in Fig. 3A.

As shown in Fig. 9A, the cells 3 and 4 are placed to have respective frames 500 and 600 partially overlapping each other so that they have bus line contact regions 51 and 52 (both cross hatched) in common. Similarly, the cells 5 and 6 are placed to have respective frames 700 and 800 partially overlapping each other so that they have bus line contact regions 71 and 72 (both cross-hatched) in common. Between cells 4 and 5 such overlap cannot be provided and their respective frames 600 and 700 abut on each other as in ordinary standard cell placement.

Thus, in cell placement in accordance with an embodiment of the present invention, such overlapping can be applied to two abutting cells even when those cells are different from each other in their functions, and an inverted bulk pattern of a cell can be introduced to facilitate overlapping whenever needed.

It is convenient to assume in a practical chip design operation according to an embodiment of the present invention that each cell and its inverted version are cells of different kinds although they originate from the same pattern information registered in the cell library. The reason for this is that two abutting cells of the same kind can not overlap each other, and one of them must be inverted for the overlapping, as mentioned above.

The above embodiments describe the placement of logic cells comprising CMOS transistors. However, embodiments of the present invention can be applied to the design of an LSI comprising transistors other than the CMOS type based on standard cell methodology, if the cell has similar bus line contact regions.

The packing density of an logic LSI based on standard cell methodology is increased by partially overlapping two adjoining cells so as to provide them with common terminal regions to be connected to the wirings for supplying power. To this end in each cell the terminal region pattern at a side edge of the cell, (the cells being disposed side by side in a row of cell in the LSI) is standardized with regard to its shape, size and edge position.

Pattern information of the cells, including information concerning the standardized terminal region pattern, is registered in the cell library of a CAD system together with a additional sign which can be displayed by the system to indicate to an operator the region of a cell available for overlap with an adjoining cell during chip design operation using a display.

An embodiment of the present invention provides a semiconductor integrated circuit comprising:

at least two kinds of circuit cells disposed in a row;

said circuit cell of each kind having a bulk pattern providing a predetermined set of circuit elements;

said bulk pattern including a pair of regions at one side of said circuit cell in the row, said regions of each pair being respectively connected to wirings for supplying positive and negative voltages;

one of said circuit cells having a pair of said regions on common with adjoining said circuit cell of different kind; and

another of said circuit cells having a pair of said regions for its exclusive use.

An embodiment of the present invention provides a method for fabricating a semiconductor integrated circuit, including a first step for providing a desired circuit by virtually placing plural kinds of circuit cells registered in advance and a second step for generating a real pattern of said circuit on a semiconductor chip, said first step comprising the steps of:

providing each of said circuit cells with a pair of regions having a pattern in common with said circuit cells, said regions to be connected to wirings for supplying positive and negative voltages; and

overlapping respective said patterns of said regions of two said circuit cells adjoining each other, when said adjoining two circuit cells have respective said regions abutting each other;

whereby a real pattern of said adjoining circuit cells has a pair of said regions in common to said circuit cells.

The first step may further comprise a step of:
providing said circuit cell with means for indicating said region.

The first step may further comprise a step of:
inverting said circuit cell to providing a pattern corresponding to a mirror image of said circuit cell.

## Claims

1. A semiconductor integrated circuit device, formed on the basis of standard cell methodology employing standard cells of different kinds each kind having a bulk pattern providing a predetermined set of circuit elements forming a respective unit circuit, said circuit elements being provided in a row of standard cells, wherein the row includes at least two adjoining cells (cell 1, cell 2) of two different kinds, characterized in that: the bulk pattern of each of those two different cell kinds includes a pair of regions (209, 210; 309, 310), for receiving respective power supply voltages ($B_{VDD}$, $B_{VSS}$), at one side of the cell, said pair of regions being designed to be standardized in common for each of various kinds of cells, and wherein the two cells are disposed in the row so that their bulk patterns partially overlap where said pair of regions are abutting each other, so that they effectively share in common one such pair of regions (21, 22).

2. A device as claimed in claim 1, wherein the row includes a third cell, the bulk pattern of whose cell kind also includes such a pair of regions, the third cell having such a pair of regions not shared with any other cell.

3. A device as claimed in claim 1 or 2, wherein the bulk pattern of one of the two different cell kinds is the mirror image of that of the other of those two different cell kinds.

4. A method of fabricating a semiconductor integrated circuit device according to claim 1 on the basis of standard cell methodology employing standard cells of different kinds each kind having a bulk pattern providing a predetermined set of circuit elements forming a respective unit circuit, the method including

a first step for designing the circuitry of the device by virtually placing cells of different kinds in desired dispositions, employing cell pattern information registered in advance, and

a second step for generating a real pattern for the circuitry to be formed on a semiconductor device chip,

the first step including providing cell pattern information for establishing a plurality of cell kinds with respective cell patterns each having a pair of regions, corresponding to portions for receiving respective power supply voltages in a fabricated cell, and

virtually placing two cells, of two different cell kinds of the plurality, such that they adjoin one another and such that the said pair of regions in the cell pattern of one of those cells overlap the said pair of regions in the cell pattern of the other of those cells, whereby a real pattern corresponding to those two cells, formed in the second step, features portions for receiving respective power supply voltages shared in common by those two cells.

5. A method as claimed in claim 4, wherein the first step includes providing information, for each of the plurality of cell kinds, indicating the said regions and indicating an allowable region of overlap with another cell kind.

6. A method as claimed in claim 4 or 5, wherein the first step includes providing the cell pattern of the said other of those cells by inverting the cell pattern of the said one of those cells.

7. A CAD system, for designing a semiconductor integrated circuit device according to claim 1 on the basis of standard cell methodology employing standard cells of different kinds each kind corresponding to a bulk pattern providing a predetermined set of circuit elements forming a respective unit circuit in a fabricated semiconductor integrated circuit device, the system comprising a cell library, storing cell pattern information for a plurality of cell kinds, each cell kind having a cell pattern including a pair of regions corresponding to portions for receiving respective power supply voltages in a fabricated cell, a display, and means whereby an operator can call up, from the cell library, information concerning each cell kind, the system being operable so that the display shows a schematic of a cell of a called-up cell kind, and so that the operator can selectively position the schematic, on the display, the system being further operable so that the schematic includes an indication of the position of the said pair of regions and an indication of the extent to which the schematic can be overlapped with the schematic of another cell so that in a finished semiconductor integrated circuit device two cells corresponding to the overlapped schematics share in common such portions for receiving respective power supply voltages.

8. A system as claimed in claim 7, operable to provide, from stored cell pattern information for one cell kind, a designation of another cell kind which has a cell pattern which is a mirror image of that of the one cell kind.

**Patentansprüche**

1. Integrierte Halbleiterschaltungsvorrichtung gebildet auf der Basis einer Standardzellenmethodologie unter Verwendung von Standardzellen von verschiedenen Arten, von denen jede Art ein Grundmuster hat, welches einen vorbestimmten Satz von Schaltungselementen umfaßt, die eine entsprechende Einheitsschaltung bilden, wobei die genannten Schaltungselemente in einer Reihe von Standardzellen angeordnet sind, bei der die Reihe wenigstens zwei aneinander angrenzende Zellen (Zelle 1, Zelle 2) von zwei verschiedenen Arten hat, dadurch gekennzeichnet, daß: das Grundmuster von jeder von jenen beiden verschiedenen Zellenarten ein Paar von Bereichen (209, 210; 309, 310) zum Empfang entsprechender Energieversorgungsspannungen ($B_{VDD}$, $B_{VSS}$) ent-

hält. an einer Seite der Zelle, das genannte Paar von Bereichen so ausgelegt ist, daß es für jede der verschiedenen Arten von Zellen gemeinsam standardisiert ist, und bei der die beiden Zellen in der Reihe so angeordnet sind, daß ihre Grundmuster sich teilweise überlappen, wo das genannte Paar von Bereichen aneinander anstößt, so daß sie effektiv gemeinsam solch ein Paar von Bereichen (21, 22) nutzen.

2. Vorrichtung nach Anspruch 1, bei der die Reihe eine dritte Zelle enthält, das Grundmuster von dieser Zellenart auch solch ein paar von Bereichen enthält, die dritte Zelle solch ein Paar von Bereichen hat, das nicht mit irgendeiner anderen Zelle gemeinsam genutzt wird.

3. Vorrichtung nach Anspruch 1 oder 2, bei der das Grundmuster von einer von den beiden verschiedenen Zellenarten das Spiegelbild von derjenigen der anderen von jenen beiden verschiedenen Zellenarten ist.

4. Verfahren zur Herstellung einer integrierten Halbleiterschaltungsvorrichtung nach Anspruch 1, auf der Basis der Standardzellenmethodologie, unter Verwendung von Standardzellen von verschiedenen Arten, von denen jede Art ein Grundmuster hat, das einen vorbestimmten Satz von Schaltungselementen enthält, die eine entsprechende Einheitsschaltung bilden, welches Verfahren umfaßt

einen ersten Sohritt der Auslegung der Schaltungen der Vorrichtung durch virtuelles Plazieren von Zellen verschiedener Arten in gewünschten Anordnungen, unter Verwendung von Zellenmusterinformation, die im voraus registriert wurde, und

einen zweiten Schritt der Erzeugung eines realen Musters für die Schaltung, die auf einem Halbleitervorrichtungchip gebildet werden soll

wobei der erste Schritt umfaßt

Bilden von Zellenmusterinformation, zur Etablierung einer Vielzahl von Zellenarten mit entsprechenden Zellenmustern, welche jeweils ein Paar von Bereichen haben, die Abschnitten zum Empfang entsprechender Energieversorgungsspannungen in einer hergestellten Zelle entsprechen, und

virtuelles Plazieren von zwei Zellen, von verschiedenen Zellenarten von der Vielzahl, so daß sie aneinander angrenzen und so daß das genannte Paar von Bereichen in dem Zellenmuster von einer von jenen Zellen das genannte Paar von Bereichen in dem Zellenmuster von der anderen von jenen Zellen überlappt, wodurch ein reales Muster, das jenen beiden Zellen entspricht, die bei dem zweiten Schritt gebildet werden, Abschnitte zmr Empfang von jeweiligen Energieversorgungsspannungen darstellen, welche von jenen beiden Zellen gemeinsam genutzt werden.

5. Verfahren naoh Anspruch 4, bei dem der erste Schritt die Lieferung von Information für jede der Vielzahl von Zellenarten umfaßt, welche die genannten Bereiche anzeigt und einen zulässigen Bereich von Überlappung mit einer anderen Zellenart anzeigt.

6. Verfahren nach Anspruch 4 oder 5, bei dem der erste Schritt die Bildung des Zellenmusters von den genannten anderen von jenen Zellen, durch Invertieren des Zellenmusters von der genannten einen von jenen Zellen, umfaßt.

7. CAD-System zum Auslegen einer integrierten Halbleiterschaltungsvorrichtung nach Anspruch 1, auf der Basis einer Standardzellenmethodologie, unter Verwendung von Standardzellen von verschiedenen Arten, die jeweils einem Grundmuster entsprechen, welches einen vorbestimmten Satz von Schaltungselementen vorsieht, die eine jeweilige Einheitsschaltung in einer hergestellten integrierten Halbleiterschaltungsvorrichtung bilden, welches System eine Zellenbibliothek umfaßt, die Zellenmusterinformation für eine Vielzahl von Zellenarten speichert, wobei jede Zellenart ein Zellenmuster hat, welches ein Paar von Bereichen umfaßt, die Abschnitten zum Empfang entsprechender Energieversorgungsspannungen in einer hergestellten Zelle entsprechen, eine Anzeige, und

Einrichtungen, durch die ein Operator, von der Zellenbibliothek, Information abrufen kann, welche jede Zellenart betrifft, wobei das System so betreibbar ist, daß die Anzeige ein Schemasohaltbild einer Zelle der aufgerufenen Zellenart anzeigt, und so, daß der Operator selektiv das Sohemaschaltbild auf der Anzeige positionieren kann,

das System ferner so betreibbar ist, daß das Schemaschaltbild die Anzeige der Position von dem genannten Paar von Bereichen und eine Anzeige von dem Ausmaß enthält, bis zu welchem das Schemaschaltbild mit dem Schemaschaltbild einer anderen Zelle überlappt sein kann, so daß in einer fertiggestellten integrierten Halbleiterschaltungsvorrichtung zwei Zellen, die den überlappenden Schemaschaltbildern entsprechen, gemeinsam solche Abschnitte für den Empfang von entsprechenden Energieversorgungsspannungen nutzen.

8. System nach Anspruch 7, betreibbar um, von gespeicherter Zellenmusterinformation für eine Zellenart, eine Bestimmung einer anderen Zellenart zu liefern, welche ein Zellenmuster hat, das ein Spiegelbild von jenem der genannten einen Zellenart ist.

**Revendications**

1. Dispositif en circuits intégrés à semiconducteur formé sur la base de la méthodologie des cellules standard utilisant des cellules standard de différents types, chaque type ayant une configuration de masse formant un ensemble prédéterminé d'éléments de circuits constituant un circuit unitaire respectif, lesdits éléments de circuits étant prévus dans une rangée de cellules standard, dans lequel la rangée comporte au moins deux cellules voisines (cellule 1, cellule 2) de deux types différents, caractérisé en ce que: la configuration de masse de chacun des ces deux types de cellules différents comprend une paire de régions (209, 210; 309, 310) pour recevoir des tensions d'alimentation respectives ($B_{VDD}$, $B_{VSS}$)

sur un côté de la cellule, ladite paire de régions étant réalisée pour étre standardisée en commun pour chacun des différents types de cellules et dans lequel les deux cellules sont disposées dans la rangée de manière que leurs configurations de masse se chevauchent partiellement à l'endroit où lesdites paires de régions s'appuient l'une contre l'autre de manière qu'elles se partagent en commun effectivement l'une des paires desdites régions (21,22).

2. Dispositif selon la revendication 1, dans lequel la rangée contient une troisième cellule, la configuration de masse de ce type de cellule comprenant également une paire de régions, la troisième cellule comprenant cette paire de régions non partagée avec une autre cellule.

3. Dispositif selon la revendication 1 ou 2, dans lequel la configuration de masse de l'un des deux types différents de cellules est l'image symétrique de celle de l'autre de ces deux types différents de cellules.

4. Procédé de fabrication d'un dispositif en circuits intégrés à semi-conducteur selon la revendication 1, sur la base de la méthodologie des cellules standard utilisant des cellules standard de différents types, chaque type ayant une configuration de masse formant un ensemble prédéterminé d'éléments de circuits constituant un circuit unitaire respectif, le procédé comprenant:

une première phase pour concevoir le circuit du dispositif en positionnant virtuellement des cellules de différents types dans des positions voulues, en utilisant des informations de configuration de cellules enregistrée à l'avance et

une seconde phase pour produire une configuration réelle du circuit à former sur une pastille d'un dispositif semi-conducteur,

la première phase consistant

à produire des informations de configuration de cellules pour établir plusieurs types de cellules avec des configurations de cellules respectives ayant chacune une paire de régions correspondant à des parties destinées à recevoir des tensions d'alimentation dans une cellule fabriquée, et

à positionner virtuellement deux cellules de deux types de cellules différents parmi les plusieurs de maniére qu'elles soient voisines 1 'une de l'autre et que ladite paire de régions dans la configuration de cellules de l'une de ces cellules chevauche ladite paire de règions dans ladite configuration de cellules de l'autre de ces cellules de manière qu'une configuration réelle correspondant à ces deux cellules, formée dans la seconde phase, caractérise dans parties pour recevoir des tensions d'alimentation respectives partagées en commun par ces deux cellules.

5. Procédé selon la revendication 4, dans lequel la première phase consiste à produire des informations pour chacun des plusieurs types de cellules, indiquant lesdites régions et indiquant une région autorisée de chevauchement avec un autre type de cellules.

6. Procédé selon la revendication 4 ou 5, dans

lequel la premiére phase consiste à produire la configuration de cellules de ladite autre de ces cellules en inversant la configuration de cellules de la première desdites cellules.

7. Systéme CAD destiné à concevoir un dispositif en circuits intégrés à semi-conducteur selon la revendication 1, sur la base de la méthodologie des cellules standard utilisant des cellules standard de différents types, chaque type correspondant à une configuration de masse formant un ensemble prédéterminé d'éléments de circuits constituant un circuit unitaire respectif dans un dispositif en circuits intégrés semi-conducteur fabriqué, le système comprenant une bibliothéque de cellules, mémorisant des informations de configuration de cellules pour plusieurs types de cellules, chaque type de cellules ayant une configuration de cellules comprenant une paire de régions correspondant à des parties pour recevoir des tension d'alimentation respectives dans une cellule fabriquée, un écrant de visualisation et un dispositif par lequel un opérateur peut appeler, dans la bibliothèque des cellules, des informations concernant chaque type de cellules, le système fonctionnant de manière que la visualisation présente un schéma d'une cellule d'un type de cellule appelé et que l'opérateur puisse positionner sélectivement le schéma sur l'écran de visualisation, le système fonctionnant en outre de manière que le schéma comprenne une indication sur la position desdites paires de régions et une indication sur l'ètendue sur laquelle le schéma peut être chevauché par le schéma d'une autre cellule de manière que dans un dispositif en circuits intégrés à semi-conducteur terminé, ceux cellules correspondant aux schémas se chevauchant se partagent en commun ces parties pour recevoir des tensions d'alimentation respectives.

8. Système selon la revendication 7, fonctionnant de manière à produire, à partir d'informations de configuration de cellules mémorisées pour chaque type de cellules, une désignation d'un autre type de cellules qui a une configuration de cellules qui est une image symétrique de celle dudit type de cellules.

## FIG.1

## FIG.2A

## FIG.2B

# FIG.2C

# FIG.2D

# FIG.3B

# FIG.3C

## FIG. 3A

## FIG.4

## FIG.9B

## FIG.5 A

12

10

14

14

13

15

15

11  16  12'

## FIG.5 B

20  30

11  16  11  16

## FIG.5 C

20'  30

11  16

16'  11'

5

# FIG.6

Flowchart:

CELL LIBRARY

↓

Fetch information of a desired cell

↓

Is the cell to overlap with another?

— No → Place the cell not to overlap with another

Yes ↓

Place the cell to overlap with another

↓

Placement of all cells completed?

No → (back to Fetch information of a desired cell)

Yes ↓

Route interconnections among the cells

↓

## FIG.7

# FIG. 8 A

400 GA P1 41 400'

401

B_VDD

205

OT

206

B_VSS

207 N1 402 42

# FIG. 8 C

41 400''

400

B_VDD

B_VSS

42

# FIG. 8 B

V_DD P1

GA

OT

N1

V_SS

# FIG.9A